# FASCICULE DE BREVET EUROPEEN

(11) **EP 0 390 016 B1**
(45) Date de publication et mention de la délivrance du brevet: **03.05.1995**
(21) Numéro de dépôt: 90105681.2
(22) Date de dépôt: 26.03.1990
(51) Int. Cl.: H01L 39/24, H01L 39/14

(54) **Procédé de fabrication d'un ruban à base d'oxyde supraconducteur**
Herstellungsverfahren eines supraleitenden oxydischen Bands
Superconducting oxide tape manufacturing method

(30) Priorité: 31.03.1989 FR 8904251
(43) Date de publication de la demande: 03.10.1990
(73) Titulaire: ALCATEL ALSTHOM COMPAGNIE GENERALE D'ELECTRICITE, 75382 Paris Cédex 08 (FR)
(72) Inventeur: Belouet, Christian, F-92330 Sceaux (FR)
(74) Mandataire: Weinmiller, Jürgen

(56) Documents cités:
- EP-A- 0 310 332
- JAPANESE JOURNAL OF APPLIED PHYSICS, vol. 27, no. 6, juin 1988, pages L1092-L1093, Tokyo, JP; T. KONAKA et al.: "Preparation of Y-Ba-Cu-O superconducting tape by atmospheric plasma spraying"
- PATENT ABSTRACTS OF JAPAN, vol. 13, no. 92 (E-722), 3 mars 1989 ; & JP-A-63 269 419
- IEEE TRANSACTIONS ON MAGNETICS, vol. 25, no. 2, mars 1989, pages 2164-2167, New York, US ; & APPLIED SUPERCONDUCTIVITY CONFERENCE, août 1988, San Francisco, US ; H. SEKINE et al. : "Studies on the non rare earth oxide superconductors fabricated by sintering"
- JAPANESE JOURNAL OF APPLIED PHYSICS, vol. 27, no. 3, février 1988, pages L185-L187, Tokyo, JP; M. OKADA et al.: "Fabrication of Ag-sheated Ba-Y-Cu oxide superconductor tape"
- PATENT ABSTRACTS OF JAPAN, vol. 13, no. 68 (E-716), 16 février 1989 ; & JP-A-63 252 318
- APPLIED PHYSICS LETTERS, vol. 51, no 12, 21 September 1987, pages 943-945, S. JIN et al. : "Fabrication of dense Ba2YCu3O7-d superconductor wire by molten oxide processing"

## Description

La présente invention concerne un procédé de fabrication d'un ruban à base d'oxyde supraconducteur.

L'élaboration de fils ou rubans à base d'oxydes supraconducteurs pour le transport de courants élevés est réalisée aujourd'hui par des techniques fondées sur la mise en forme de poudres de ces matériaux : sérigraphie, extrusion sous gaine métallique, etc...

Ces procédés n'ont pas permis jusqu'ici d'obtenir des densités de courant Jc souhaitées, soit Jc (77K) ∼ 10⁴ A/cm² sous champ nul. Les meilleurs résultats connus sont de quelques 10³ A/cm² avec une dégradation en général importante sous champ magnétique. Ainsi, pour les oxydes supraconducteurs à haute température de type Y-Ba-Cu-O, Bi-Sr-Ca-Cu-O et T1-Ba-Ca-Cu-O, les valeurs de Jc sont très éloignées des valeurs intrinsèques Jc (77K) ∼ 10⁶ A/cm² avec une faible sensibilité au champ magnétique, mesurées sur films minces orientés ou sur monocristaux.

L'article "Laser - Heated Pedestal Growth of High Tc Bi-Sr-Ca-Cu-O superconducting fibers" de D. Gazit et R.S. Feigelson paru dans le Journal of Crystal Growth 91 (1988) 318-330, propose la fabrication d'une fibre de 0,1 à 1 mm de diamètre en oxyde supraconducteur, par croissance à partir d'une zone fondue extrêmement fine. Une telle fibre est toutefois très difficile à réaliser.

Les mêmes problèmes de mise en oeuvre se posent pour les structures à base de fibres de Cu₂O noyées dans une matrice orientée de matériau supraconducteur La₂₋ₓSrₓ CuO₄ décrits dans l'article "Growth and anisotropic magnetic behaviour of aligned eutectic - type structures in the system La₂₋ₓ Srₓ CuO₄ - Copper oxide" de L. Trouilleux, G. Dhalenne et A. Revcolevschi - (Journal of Crystal Growth 91 (1988) 268-273).

L'article paru dans Applied Physics Letters, vol. 51, n° 12, 21 septembre 1987, pages 943-945 S. JIN et al "Fabrication of dense Ba₂ YCu₃ O_{7-δ} superconductor wire by molten oxide processing" concerne un procédé de fabrication de fils ou de rubans supraconducteurs consistant à utiliser un noyau métallique recouvert d'une couche d'oxyde frittée, à chauffer cette couche d'oxyde jusqu'à la fusion, et à traiter thermiquement sous oxygène. Ce procédé ne permet pas d'obtenir un ruban ayant une densité de courant Jc suffisante.

La présente invention a pour but de réaliser des rubans à base d'oxyde supraconducteur de manière plus aisée que les fils ou les fibres connus jusqu'à présent, et permettant d'aboutir à des densités de courant élevées.

La présente invention a pour objet un procédé de fabrication d'un ruban à base d'oxyde supraconducteur contenant Cu-O, caractérisé par le fait que l'on immerge une extrémité d'un substrat en matériau flexible métallique ou composite, de section transversale rectangulaire, dans un bain d'un oxyde supraconducteur de type perovskite à fusion congruente, ou quasi-congruente, ou à décomposition péritectique proche d'un point eutectique, que l'on fait défiler ledit substrat de bas en haut à une vitesse comprise entre 1 et 100 cm par minute, et que l'on fait subir ensuite un traitement thermique audit substrat recouvert d'un film à base dudit oxyde supraconducteur cristallisé.

A tout moment, une partie seulement du substrat est immergée. On réalise un dépôt en continu d'un film liquide d'oxyde supraconducteur, grâce à une alimentation en continu du bain avec une composition adaptée.

L'épaisseur dudit film est de préférence comprise entre 1 »m et 100 »m.

L'épaisseur dudit substrat est de préférence comprise entre 25 »m et 100 »m.

La texture du film déposé sur le substrat est d'abord caractérisée par l'absence de cavités, ce qui confère à la fraction de matériau supraconducteur du film une densité volumique égale à la densité intrinsèque. De plus cette texture est caractérisée par une orientation des plans Cu-O des cristaux supraconducteurs, commune et parallèle au plan de la surface du substrat. L'ensemble de ces deux caractéristiques permet d'atteindre des valeurs de la densité de courant critique Jc (77K) très élevées, à l'instar de ce qui a été déjà démontré dans le cas de monocristaux massifs de ces matériaux : par exemple Jc (77k) ~ 10⁶ A/cm² pour Y-Ba-Cu-O.

Selon un exemple de mise en oeuvre, ledit oxyde de type perovskite à décomposition péritectique proche d'un point eutectique est choisi parmi les oxydes Bi-Sr-Ca-Cu-O et parmi les composés de la famille Y-Ba-Cu-O où l'yttrium est remplacé par des terres rares, telles que par exemple l'europium ou l'ytterbium.
Dans ce cas, le film obtenu est constitué de deux phases, dont une est une phase continue supraconductrice.

D'autres caractéristiques et des avantages de la présente invention apparaîtront au cours de la description suivante d'un mode de réalisation donné à titre illustratif mais nullement limitatif. Dans le dessin annexé :
- La figure 1 est un schéma de principe du dispositif permettant la mise en oeuvre du procédé de fabrication d'un ruban selon l'invention.
- La figure 2 montre un diagramme de phase (température-concentration) d'un premier composé selon l'invention.
- La figure 3 montre un diagramme de phase pour un autre composé selon l'invention.

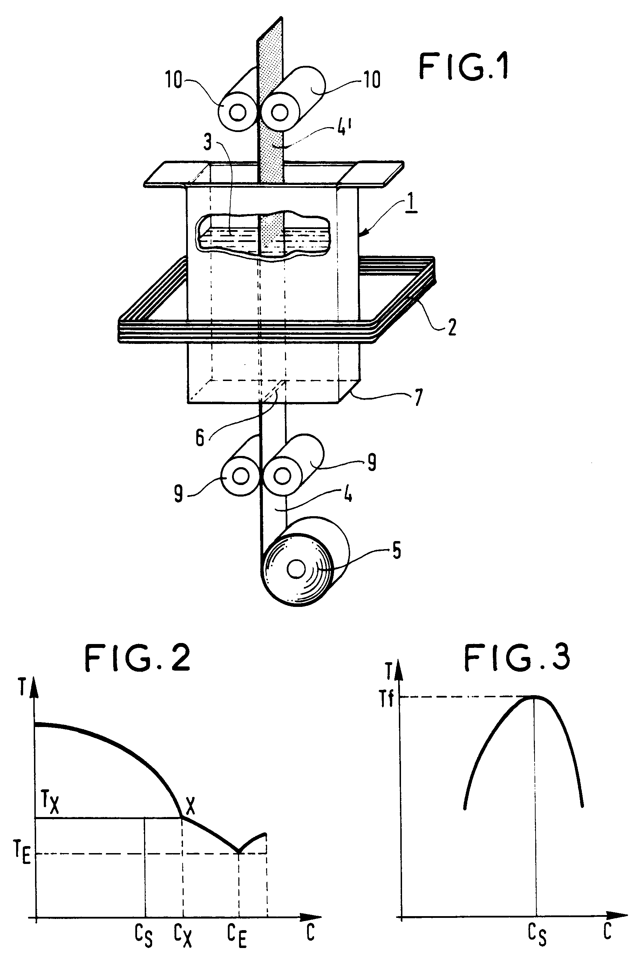

On voit dans la figure 1 un creuset 1 associé à des moyens de chauffage 2 et contenant un bain fondu d'oxyde supraconducteur 3.

On souhaite obtenir un composé supraconducteur de formule Bi₂ Sr₂ Ca Cu₂ Oₓ. Pour cela le bain 3 comprend des composés de formules Bi_{1,8} Sr_{1,8} Ca_{1,2} Cu_{2,2} O_{8-δ} à Bi₂ Sr₂ Ca Cu₂ O₈. La température du bain 3 est de l'ordre de 900°C ; elle est ajustable selon la pression partielle d'oxygène dans la phase gazeuse. Le composé considéré est un composé à décomposition péritectique proche du point eutectique. On a illustré dans la figure 2 le diagramme de fusion (température T, concentration C d'un tel composé) où figurent la température T_{E} et la composition C_{E} de ce point eutectique, ainsi que la composition C_{S} du matériau supraconducteur à cristalliser.

Un ruban de cuivre 4, de largeur 5mm et d'épaisseur 50 »m, stocké sur une bobine 5, passe à travers une fente 6 prévue dans le fond 7 du creuset 1. Des moyens d'entrainement schématisés par des rouleaux 9 et 10 entraînent le ruban 4 verticalement à travers le bain 3 à une vitesse de 1cm par minute. A la sortie le ruban 4′ est muni sur ses deux faces d'un film mince d'oxyde supraconducteur, dont l'épaisseur est de l'ordre de 100 »m.

Le point de fonctionnement X (Cₓ, Tₓ) peut être choisi conformément à la méthode proposée par D.Gazit et R.S. Feigelson dans l'article précité "Laser - Heated Pedestal Growth of High Tc Bi-Sr-Ca-Cu-O superconducting fibers".

Au cours de la cristallisation apparaît le composé supraconducteur recherché, de composition cationique Bi₂ Sr₂ Ca Cu₂, représentée par C_{S} dans le diagramme de phase de la figure 2, et une ou plusieurs phases cristallines non supraconductrices telles que Sr Ca Cu₂ O₄.

Le ruban obtenu subit alors un traitement thermique, qui est par exemple un recuit d'environ 12 heures sous oxygène vers 500°C.

Un tel traitement thermique est mentionné en détail dans l'article de T. Iwata, et al "Growth of Superconducting single-Crystal Bi-Sr-Ca-Cu-O" paru dans J. Crystal Growth 91 (1988) 282.

Le film supraconducteur obtenu après traitement est tel que les cristaux présentent leur axe C perpendiculaire aux faces du substrat. Les valeurs de la densité de courant critique Jc à 77°K sont supérieures ou égales à 10⁴ A/cm².

Dans l'exemple qui vient d'être décrit, la vitesse de tirage est limitée par la vitesse de diffusion des espèces qui cristallisent dans le bain liquide 3.

Dans le cas d'un composé supraconducteur à fusion congruente ou quasi-congruente, les compositions du bain et du film sont identiques. On a représenté schématiquement dans la figure 3 une partie du diagramme concentration-température correspondant. C_{S} représente la composition du bain du composé supraconducteur recherché. La vitesse de tirage n'est limitée que par l'élimination de la chaleur latente à l'interface de cristallisation. Elle peut donc atteindre typiquement 10cm/minute pour un film d'épaisseur voisine de 100 »m.

Bien entendu la vitesse de tirage dépend de l'épaisseur du film déposé et des caractéristiques du substrat.

L'invention n'est pas limitée au mode de réalisation décrit et illustré.

## Revendications

1. Procédé de fabrication d'un ruban à base d'oxyde supraconducteur contenant Cu-O, caractérisé par le fait que l'on immerge une extrémité d'un substrat (4) en matériau flexible métallique ou composite, de section transversale rectangulaire, dans un bain d'un oxyde supraconducteur de type perovskite à fusion congruente, ou quasi-congruente, ou à décomposition péritectique proche d'un point eutectique, que l'on fait défiler ledit substrat de bas en haut à une vitesse comprise entre 1 et 100 cm par minute, et que l'on fait subir ensuite un traitement thermique audit substrat recouvert d'un film à base dudit oxyde supraconducteur cristallisé.

2. Procédé de fabrication selon la revendication 1, caractérisé par le fait que l'épaisseur dudit film est comprise entre 1 »m et 100 »m.

3. Procédé de fabrication selon l'une des revendications 1 et 2, caractérisé par le fait que l'épaisseur dudit substrat est comprise entre 25 »m et 100 »m.

4. Procédé de fabrication selon l'une des revendications précédentes, caractérisé par le fait que ledit oxyde supraconducteur est choisi parmi les oxydes Bi-Sr-Ca-Cu-O et les composés de la famille RE-Ba-Cu-O où RE est une terre rare autre que l'yttrium.

5. Procédé de fabrication selon la revendication 4, caractérisé par le fait que ladite terre rare est choisie parmi l'europium et l'ytterbium.

## Patentansprüche

1. Herstellungsverfahren für ein Band auf der Basis eines Cu-O enthaltenden supraleitenden Oxids, dadurch gekennzeichnet, daß man ein Ende eines Substrats (4) aus biegsamem Metall- oder Verbundmaterial eines rechteckigen Querschnitts in ein Bad eines supraleitenden Oxids der Art Perovskit mit kongruentem oder quasi-kongruentem Schmelzen oder mit peritektischer Zersetzung nahe einem eutektischen Punkt eintaucht, das Substrat von unten nach oben mit einer Geschwindigkeit durchzieht, die zwischen 1 und 100 cm pro Minute liegt, und dann dieses mit einem Film auf der Basis des kristallisierten supraleitenden Oxids bedeckte Substrat einer Wärmebehandlung unterzieht.

2. Herstellungsverfahren nach Anspruch 1, dadurch gekennzeichnet, daß die Dicke des Films zwischen 1 »m und 100 »m liegt.

3. Herstellungsverfahren nach einem der Ansprüche 1 und 2, dadurch gekennzeichnet, daß die Dicke des Substrats zwischen 25 »m und 100 »m liegt.

4. Herstellungsverfahren nach einem der vorhergehenden Ansprüche, dadurch gekennzeichnet, daß das supraleitende Oxid aus den Oxiden Bi-Sr-Ca-Cu-O und den Verbundmaterialien der Familie RE-Ba-Cu-O ausgewählt wird, wobei RE eine seltene Erde außer Yttrium ist.

5. Herstellungsverfahren nach Anspruch 4, dadurch gekennzeichnet, daß die ausgewählte seltene Erde Europium oder Ytterbium ist.

## Claims

1. A method of manufacturing a tape based on a superconducting oxide containing Cu-O, the method being characterized by the facts that one end of a substrate (4) of flexible metal or composite material having a rectangular cross-section is immersed in a bath of perovskite type superconducting oxide having congruent or quasi-congruent melting or peritectic decomposition close to a eutectic point, that said substrate is caused to travel upwards at a speed lying in the range 1 cm per minute to 100 cm per minute, and that said substrate covered with the crystallized film based on said superconducting oxide is then subjected to heat treatment.

2. A method of manufacture according to claim 1, characterized by the fact that the thickness of said film lies in the range 1 »m to 100 »m.

3. A method of manufacture according to claim 1 or 2, characterized by the fact that the thickness of said substrate lies in the range 25 »m to 100 »m.

4. A method of manufacture according to any preceding claim, characterized by the fact that said superconducting oxide is selected from Bi-Sr-Ca-Cu-O oxides and from compounds of the family RE-Ba-Cu-O where RE is a rare earth other than yttrium.

5. A method of manufacture according to claim 4, characterized by the fact that said rare earth is selected from europium and ytterbium.
